Europäisches Patentamt

European Patent Office

Office européen des brevets

(19)

(11)  **EP 1 732 315 A1**

(12)  **EUROPEAN PATENT APPLICATION**
published in accordance with Art. 158(3) EPC

(43) Date of publication:
**13.12.2006 Bulletin 2006/50**

(51) Int Cl.:
*H04N 5/335* (2006.01)          *G01J 1/44* (2006.01)
*G01J 1/46* (2006.01)

(21) Application number: **05727978.8**

(22) Date of filing: **31.03.2005**

(86) International application number:
**PCT/JP2005/006301**

(87) International publication number:
**WO 2005/096622 (13.10.2005 Gazette 2005/41)**

(84) Designated Contracting States:
**DE FR GB**

(30) Priority:  **01.04.2004  JP 2004109301**

(71) Applicant: **HAMAMATSU PHOTONICS K. K.**
**Hamamatsu-shi, Shizuoka 435-8558 (JP)**

(72) Inventors:
• **MIZUNO, Seiichiro,**
  **Hamamatsu Photonics K.K.**
  **Hamamatsu-shi, Shizuoka 4358558 (JP)**

• **FUNAKOSHI, Haruhiro,**
  **Hamamatsu Photonics K.K.**
  **Hamamatsu-shi, Shizuoka 4358558 (JP)**
• **TAKA, Tetsuya,**
  **Hamamatsu Photonics K.K.**
  **Hamamatsu-shi, Shizuoka 4358558 (JP)**

(74) Representative: **Frost, Alex John**
  **Boult Wade Tennant,**
  **Verulam Gardens**
  **70 Gray's Inn Road**
  **London WC1X 8BT (GB)**

(54)  **LIGHT RECEIVING PART AND SOLID-STATE IMAGE PICKUP DEVICE**

(57)  A transmission transistor $T_2$ transfers charges generated in a photodiode PD to a first capacitor part $C_{11}$ via a first switch $SW_{11}$, and transfers the charges to a second capacitor part $C_{12}$ via a second switch $SW_{12}$. An amplification transistor $T_1$ outputs a voltage corresponding to the amount of accumulated charges in at least one of a first capacitor part $C_{11}$ and a second capacitor part $C_{12}$, connected to a gate terminal, and a gate terminal of the amplification transistor $T_1$ is connected to at least one of the first capacitor part $C_{11}$ and the second capacitor part $C_{12}$.

**Fig.3**

**Description**

**Technical Field**

This invention relates to a photosensitive part and a solid-state image pickup device.

**Background Art**

A solid-state image pickup device is provided with a light detecting part in which a plurality of photosensitive parts are one-dimensionally or two-dimensionally arranged. The solid-state image pickup device can output an electric signal value denoting the incident intensity to the photosensitive part in each pixel position from the photosensitive part, and pick up an image based on the electric signal value. In such a solid-state image pickup device, when the difference in the amount of incident light between pixel positions is large (that is, when the contrast of the image which should be picked up is high), it is required that the image having excellent contrast is obtained by picking up.

However, a photo sensor circuit disclosed in Patent Document 1 includes a photodiode as the photosensitive part, accumulates the charges generated by the optical incidence to the photodiode in the capacity part in the integration circuit, and outputs the voltage corresponding to the amount of accumulated charges from the integration circuit. In this solid-state image pickup device, the capacity value of the capacity part in the integration circuit is variable, and thereby the expansion of the dynamic range of optical detection is attained. It is considered that the solid-state image pickup device capable of obtaining an image having excellent contrast by picking up can be realized by using a technique disclosed in Patent Document 1 in the solid-state image pickup device.

Patent Document 1: Japanese Patent No. 3146502

**Disclosure of the Invention**

**Problems to be Solved by the Invention**

In the technique disclosed in Patent Document 1, an optical detection having high sensitivity when the amount of incident light is small can be performed by reducing the capacity value of the capacity part of the integration circuit. Therefore, the signal charges outputted from the photodiode are amplified by the integration circuit and a noise is also amplified by the integration circuit. Thereby, the S/N ratio of the optical detection is poor. Even if the solid-state image pickup device using the technique disclosed in Patent Document 1 can obtain the image having excellent contrast, the S/N ratio of the image is poor.

The present invention has been developed to eliminate the problem described above, and it is an object of the present invention to provide a solid-state image pickup device capable of obtaining the image having excellent contrast and S/N ratio, and a photosensitive part suitably used in the solid-state image pickup device.

**Means for Solving the Problem**

A photosensitive part according to the present invention comprising:

(1) a photodiode for generating charges corresponding to the intensity of incident light;
(2) a first capacitor part and a second capacitor part for respectively accumulating the charges;
(3) an amplification transistor having a gate terminal connected to at least one of the first capacitor part and the second capacitor part and outputting a voltage corresponding to the charges accumulated in at least one of the first capacitor part and the second capacitor part, connected to the gate terminal;
(4) a transmission transistor for transferring the charges generated in the photodiode to the first capacitor part via a first switch and transferring the charges to the second capacitor part via a second switch;
(5) a discharge transistor for initializing the charges of each of the first capacitor part and the second capacitor part; and
(6) a selection transistor for alternatively outputting the voltage outputted from the amplification transistor.

This photosensitive part is provided with the first capacitor part and second capacitor part for respectively accumulating the charges, and the charges of the first capacitor part and second capacitor part are initialized by the discharge transistor. The charges generated in the photodiode according to the light incidence is transferred to the first capacitor part via the first switch through the transmission transistor, and is transferred to the second capacitor part via the second switch. The gate terminal of the amplification transistor is connected to at least one of the first capacitor part and the second capacitor part, and the voltage corresponding to the charges accumulated in at least one of the first capacitor part and the second capacitor part, connected to the gate terminal is outputted through the amplification transistor and the selection transistor.

A solid-state image pickup device of the present invention comprising:

(1) a light detecting part including sections $A_{1,1}$ to $A_{M,N}$ of MxN pieces one-dimensionally or two-dimensionally arranged and having the photosensitive parts of K pieces according to the present invention arranged in a section $A_{m,n}$ in the m-th line and n-th column;

(2) a holding part for holding first voltages outputted through the selection transistor from the amplification transistor when the gate terminal of the amplification transistor of each of the photosensitive part of K pieces contained in the section $A_{m,n}$ is connected to at least one of the first capacitor part and the second capacitor part, and holding second voltages outputted through the selection transistor from the amplification transistor when the gate terminal of the amplification transistor is connected to both the first capacitor part and the second capacitor part; and

(3) a calculating part for calculating and outputting the added value of the first voltages outputted from each of the photosensitive parts of K pieces contained in the section $A_{m,n}$ and held by the holding part, and calculating and outputting the average value of the second voltages outputted from each of the photosensitive part of K pieces contained in the section $A_{m,n}$ and held by the holding part, wherein M and N are an integer of 1 or more; at least one of M and N is an integer of 2 or more; K is an integer of 2 or more; m is an optional integer of 1 to M; and n is an optional integer of 1 to N. Herein, it is preferable that the solid-state image pickup device further comprises a selecting part for inputting the added value and average value outputted from the calculating part for each section $A_{m,n}$, outputting the added value when the absolute value of the added value is smaller than a predetermined value and outputting the average value when not so.

In the light detecting part of the solid-state image pickup device, the sections $A_{1,1}$ to $A_{M,N}$ of M×N pieces are one-dimensionally or two-dimensionally arranged, and the photosensitive parts of K pieces according to the present invention are arranged in the section $A_{m,n}$ in the m-th line and n-th column. The first voltage outputted through the selection transistor from the amplification transistor when the gate terminal of the amplification transistor of each of the photosensitive part of K pieces contained in the section $A_{m,n}$ is connected to at least one of the first capacitor part and the second capacitor part, and the second voltage outputted through the selection transistor from the amplification transistor when the gate terminal of the amplification transistor is connected to both the first capacitor part and the second capacitor part are held by the holding part.

The calculating part calculates and outputs the added value of the first voltage outputted from each of the photosensitive parts of K pieces contained in the section $A_{m,n}$ and held by the holding part, and calculates and outputs the average value of the second voltage outputted from each of the photosensitive part of K pieces contained in the section $A_{m,n}$ and held by the holding part. When the selecting part is further provided, the selecting part inputs the added value and average value outputted from the calculating part for each section $A_{m,n}$, selects and outputs the added value when the absolute value of the added value is smaller than the predetermined value, and selects and outputs the average value when not so.

It is preferable that the solid-state image pickup device according to the present invention, further comprises:

(1) a connection switching part having a first end provided for each of the photosensitive parts of K pieces contained in the section $A_{m,n}$ and connected to the discharge transistor of the photosensitive part, and a second end for inputting bias potential for initializing the charges of each of the first capacitor part and second capacitor part of the photosensitive part, and a third end, and electrically connecting between the first end and the second end, or between the first end and the third end; and (2) an integration circuit having an input terminal connected to the third end of the connection switching part, accumulating the charges flowing-in through the first end and the third end of the connection switching part from the photosensitive parts of K pieces contained in the section $A_{m,n}$ in a capacitor, and outputting the integration value corresponding to the amount of accumulated charges.

It is preferable that the solid-state image pickup device further comprises a selecting part for inputting the added value and average value outputted from the calculating part for each section $A_{m,n}$, inputting the integration value outputted from the integration circuit, outputting the added value when the absolute value of the added value is smaller than a first predetermined value, outputting the average value when the absolute value of the added value is larger than the first predetermined value and the absolute value of the average value is smaller than a second predetermined value, and outputting the integration value in neither case.

In this case, the charges generated in the photodiode of each of the photosensitive parts of K pieces contained in a certain section $A_{m,n}$ are inputted into the integration circuit through the connection switching part, and are accumulated in the capacitor of the integration circuit. The integration value corresponding to the amount of accumulated charges is outputted from the integration circuit. When the selecting part is further provided, any of the added value and average value outputted from the calculating part, and the integration value outputted from the integration circuit is selected for each section $A_{m,n}$ by the selecting part and is outputted.

**Effects of the Invention**

The solid-state image pickup device according to the present invention can obtain an image excellent in both contrast and an S/N ratio.

**Brief Description of the Drawings**

FIG. 1 is a schematic block diagram of a solid-state image pickup device 1 according to the embodiment.

FIG. 2 is a block diagram of a section $A_{m,n}$ in a light detecting part 10 and holding circuit $H_n$ in a holding part 20 of the solid-state image pickup device 1 according to the embodiment.
FIG. 3 is a circuit diagram of a photosensitive part $a_{i,j}$ of the section $A_{m,n}$ in the light detecting part 10 and partial holding circuit $h_{i,j}$ of the holding circuit $H_n$ in the holding part 20 of the solid-state image pickup device 1 according to the embodiment.
FIG. 4 is a sectional view of a photodiode PD.
FIG. 5 is an explanatory view of a calculating part 30 of the solid-state image pickup device 1 according to the embodiment.
FIG. 6 is a circuit diagram of an integration circuit 40 and CDS circuit 50 of the solid-state image pickup device 1 according to the embodiment.
FIG. 7 is a timing chart for explaining the operation of the solid-state image pickup device 1 according to the embodiment.
FIG. 8 is a timing chart for explaining the operation of the solid-state image pickup device 1 according to the embodiment.

**Description of the Symbols**

1;      solid-state image pickup device
10;     light detecting part
20;     holding part
30;     calculating part
40;     integration circuit
50;     CDS circuit
60;     selecting part
70;     A/D converter circuit
80;     bit shift circuit

**Best Modes for Carrying Out the Invention**

Hereinafter, the embodiments of the present invention will be described in detail with reference to the accompanying drawings. In the description of the drawings, identical components are designated by the same reference numerals, and overlapping description is omitted.

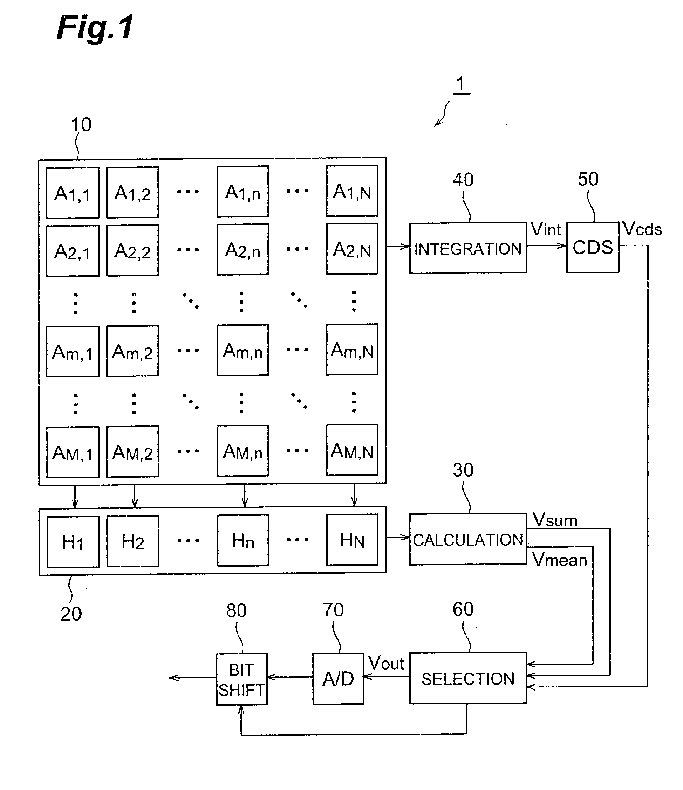

FIG. 1 is a schematic block diagram of a solid-state image pickup device 1 according to the embodiment.
The solid-state image pickup device 1 shown in the figure is provided with a light detecting part 10, a holding part 20, a calculating part 30, an integration circuit 40, a CDS circuit 50, a selecting part 60, an A/D converter circuit 70 and a bit shift circuit 80. Although lines are shown between components in the figure, the number of lines is not necessarily in agreement with the actual number of lines.
The light detecting part 10 contains sections $A_{1,1}$ to $A_{M,N}$ of M×N pieces one-dimensionally or two-dimensionally arranged and having a common constitution in a substantially rectangular region as a whole. The section $A_{m,n}$ is located in the m-th line and n-th column. As described below, photosensitive parts of K pieces are arranged in each section $A_{m,n}$. M and N are an integer of 1 or more; at least one of M and N is an integer of 2 or more; K is an integer of 2 or more; m is an optional integer of 1 to M; and n is an optional integer of 1 to N.
The holding part 20 contains holding circuits $H_1$ to $H_N$ of N pieces having a common constitution. Each holding circuit $H_n$ is provided so as to correspond to the sections $A_{1,n}$ to $A_{M,n}$ of M pieces in the n-th column in the light detecting part 10. The voltage held and outputted by each of the holding circuits $H_1$ to $H_N$ of N pieces in the holding part 20 is inputted into the calculating part 30, and the calculating part 30 performs a required operation based on the input voltage, and outputs a voltage denoting the operation result.

Only one integration circuit 40 is provided for the section $A_{1,1}$ to $A_{M,N}$ of $M \times N$ pieces in the light detecting part 10. This integration circuit 40 accumulates the charges outputted from the photosensitive parts of K pieces contained in each section $A_{m,n}$ in the light detecting part 10 in a capacitor, and outputs the voltage corresponding to the amount of accumulated charges. The voltage outputted from the integration circuit is inputted into the CDS (Correlated Double Sampling) circuit 50, and the CDS circuit 50 outputs the voltage corresponding to the difference in input voltages in a certain time and another time.

The voltages outputted from the calculating part 30 and the CDS circuit 50 are inputted into the selecting part 60, and the selecting part 60 selects and outputs any one voltage thereof. The voltage (analog value) outputted from the selecting part 60 is inputted into the A/D converter circuit 70, and the A/D converter circuit 70 converts this voltage into a digital value, and outputs this digital value. The digital value outputted from the A/D converter circuit 70 is inputted into the bit shift circuit 80, and the bit shift circuit 80 shifts and outputs the digital value by only the required number of bits in accordance with any selected in the selecting part 60.

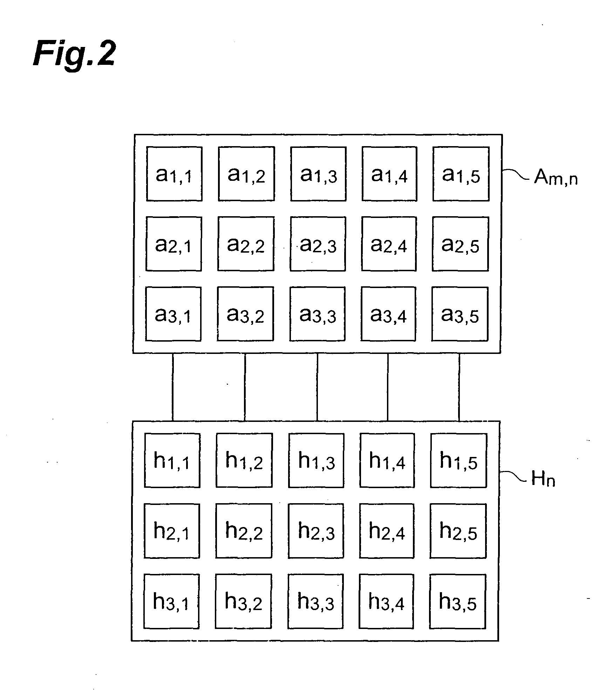

FIG. 2 is a block diagram of the section $A_{m,n}$ in the light-detecting part 10 and holding circuit $H_n$ in the holding part 20 of the solid-state image pickup device 1 according to the embodiment. The photosensitive parts (K= 15 in this embodiment) $a_{1,1}$ to $a_{3,5}$ of K pieces having a shared constitution are arranged in each section $A_{m,n}$. Each holding circuit $H_n$ includes partial holding circuits $h_{1,1}$ to $h_{3,5}$ of 15 pieces having a common constitution. The partial holding circuit $h_{i,j}$ in each holding circuit $H_n$ is provided so as to correspond to the photosensitive part $a_{i,j}$ of each of the sections $A_{1,n}$ to $A_{M,n}$ of M pieces in the n-th column in the light detecting part 10. However, i is an optional integer of 1 to 3, and j is an optional integer of 1 to 5.

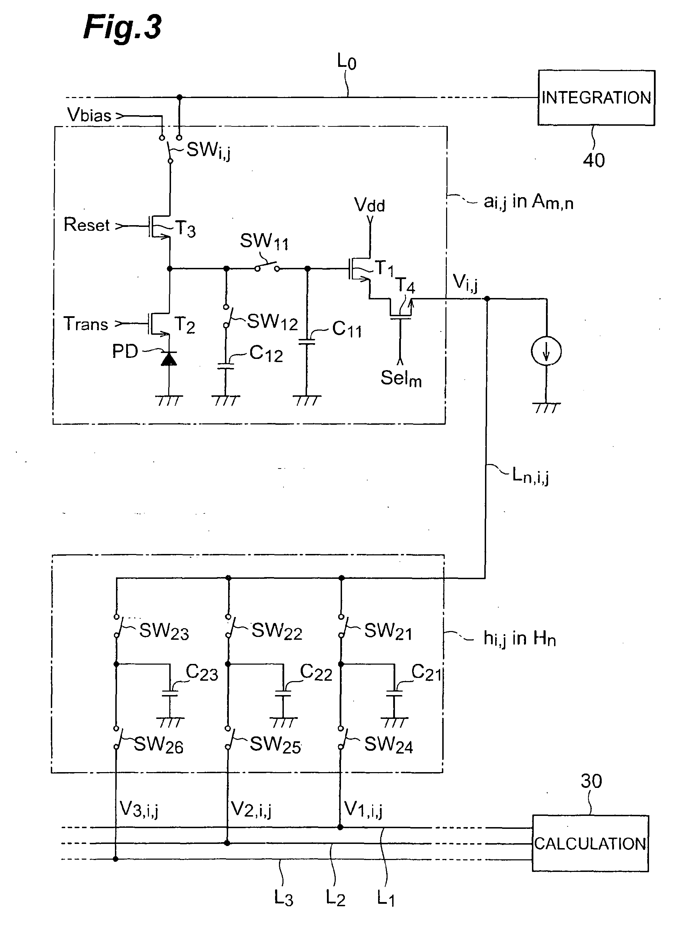

FIG. 3 is a circuit diagram of the photosensitive part $a_{i,j}$ of the section $A_{m,n}$ in the light detecting part 10 and partial holding circuit $h_{i,j}$ of the holding circuit $H_n$ in the holding part 20 of the solid-state image pickup device 1 according to the embodiment. Each photosensitive part $a_{i,j}$ is provided with the photodiode PD for generating charges corresponding to the intensity of incident light, a first capacitor part $C_{11}$ and second capacitor part $C_{12}$, respectively, accumulating the charges, an amplification transistor $T_1$ in which a gate terminal is connected to at least one of the first capacitor part $C_{11}$ and the second capacitor part $C_{12}$, a transmission transistor $T_2$ for transferring the charges generated in the photodiode PD to the first capacitor part $C_{11}$ or the second capacitor part $C_{12}$, a discharge transistor $T_3$ for respectively initializing the charges of the first capacitor part $C_{11}$ and second capacitor part $C_{12}$, and a selection transistor $T_4$ for alternatively outputting the voltage outputted from the amplification transistor $T_1$.

The gate terminal of the amplification transistor $T_1$ is directly connects to the first capacitor part $C_{11}$, and the gate terminal is connected to the second capacitor part $C_{12}$ via the first switch $SW_{11}$ and the second switch $SW_{12}$. A drain terminal of the amplification transistor $T_1$ is set to a bias potential $V_{dd}$. A source terminal of the amplification transistor $T_1$ is connected to a drain terminal of the selection transistor $T_4$. A source terminal of the selection transistor $T_4$ is connected to a line $L_{n,i,j}$. The other end of each of the first capacitor part $C_{11}$ and second capacitor part $C_{12}$ is grounded. The first capacitor part $C_{11}$ and the second capacitor part $C_{12}$ may be respectively a parasitic capacitance, or may be a capacity part made intentionally.

A drain terminal of the transmission transistor $T_2$ is connected to a source terminal of the discharge transistor $T_3$, and is connected to the gate terminal of the first capacitor part $C_{11}$ and the amplification transistor $T_1$ via the first switch $SW_{11}$. The drain terminal is connected to the second capacitor part $C_{12}$ via the second switch $SW_{12}$. A source terminal of the transmission transistor $T_2$ is connected to a cathode terminal of the photodiode PD. An anode terminal of the photodiode PD is grounded. A drain terminal, of the discharge transistor $T_3$ is connected to a switch $SW_{i,j}$.

A transmission control signal Trans into the gate terminal is inputted into the transmission transistor $T_2$, and the transmission transistor $T_2$ transfers the charges generated in the photodiode PD to the capacity part $C_{11}$ or $C_{12}$ when the transmission control signal Trans is at a high level and the switch $SW_{11}$ or $SW_{12}$ is closed. A discharge control signal Reset is inputted into the gate terminal of the discharge transistor $T_3$, and the discharge transistor $T_3$ reduces the resistance between the switch $SW_{i,j}$ and the source tenninal of the discharge transistor $T_3$ when the discharge control signal Reset is at a high level. A m-th line select control signal $Sel_m$ is inputted into the gate terminal of the selection transistor $T_4$, and the selection transistor $T_4$ outputs the voltage outputted from the amplification transistor $T_1$ to the line $L_{n,i,j}$ when the m-th line select control signal $Sel_m$ is at a high level.

Each line $L_{n,i,j}$ is connected to the selection transistor $T_4$ of the photosensitive part $a_{i,j}$ of each of the sections $A_{l,n}$ to $A_{M,n}$ of M pieces in the n-th column in the light detecting part 10. A constant current source is connected to each line $L_{n,i,j}$, and the amplification transistor $T_1$ and the selection transistor $T_4$ of each photosensitive part $a_{i,j}$ constitute a source follower circuit.

The switch $SW_{i,j}$ acts as the connection switching part provided for each photosensitive part $a_{i,j}$. The switch $SW_{i,j}$ has a first end connected to the discharge transistor $T_3$ of the photosensitive part $a_{i,j}$, a second end for inputting a bias potential $V_{bias}$ for initializing the charges of each of the first capacitor part $C_{11}$ and second capacitor part $C_{12}$ of

the photosensitive part $a_{i,j}$, and a third end connected to the input end of the integration circuit 40 via a line $L_0$. The first end is electrically connected to the second end, or the first end is electrically connected to the third end.

This switch $SW_{i,j}$ inputs bias potential $V_{bias}$ into the discharge transistor $T_3$ when the first end is electrically connected to the second end. When the first end is electrically connected to the third end, and the discharge control signal Reset and transmission control signal Trans are respectively at a high level, the switch $SW_{i,j}$ inputs the charges generated in the photodiode PD in the photosensitive part $a_{i,j}$ into the integration circuit 40.

As shown in FIG. 3, each partial holding circuit $h_{i,j}$ is provided with switches $SW_{21}$ to $SW_{26}$ and the capacitors $C_{21}$ to $C_{23}$. Each partial holding circuit $h_{i,j}$ can hold three voltages corresponding to the capacitors $C_{21}$ to $C_{23}$.

The one end of the switch $SW_{21}$ is connected to the one end of the switch $SW_{24}$. The other end of the switch $SW_{21}$ is connected to the line $L_{n,i,j}$, and the other end of the switch $SW_{24}$ is connected to the line $L_1$. The capacitor $C_{21}$ is provided between the connecting point of the switch $SW_{21}$ and switch $SW_{24}$, and the grounding potential. If the switch $SW_{21}$ changes to an open state from a closed state when the switch $SW_{24}$ is opened, the voltage $V_{i,j}$ inputted through the line $L_{n,i,j}$ just before the switch $SW_{21}$ changes to the open state is held in the capacitor $C_{21}$. When the switch $SW_{21}$ is opened and the switch $SW_{24}$ is closed, the voltage $V_{1,i,j}$ held in the capacitor $C_{21}$ is outputted to the line $L_1$.

The one end of the switch $SW_{22}$ is mutually connected to the one end of the switch $SW_{25}$. The other end of the switch $SW_{22}$ is connected to the line $L_{n,i,j}$, and the other end of the switch $SW_{25}$ is connected to the line $L_2$. The capacitor $C_{22}$ is provided between the connecting point of the switch $SW_{22}$ and switch $SW_{25}$, and the grounding potential. If the switch $SW_{22}$ changes to the open state from the closed state when the switch $SW_{25}$ is opened, the voltage $V_{i,j}$ inputted through the line $L_{n,i,j}$ just before the switch $SW_{22}$ changes to the open state is held in the capacitor $C_{22}$. When the switch $SW_{22}$ is opened and the switch $SW_{25}$ is closed, the voltage $V_{2,i,j}$ held in the capacitor $C_{22}$ is outputted to the line $L_2$.

The one end of the switch $SW_{23}$ is connected to the one end of the switch $SW_{26}$. The other end of the switch $SW_{23}$ is connected to the line $L_{n,i,j}$, and the other end of the switch $SW_{26}$ is connected to the line $L_3$. The capacitor $C_{23}$ is provided between the connecting point of the switch $SW_{23}$ and switch $SW_{26}$, and grounding potential. When the switch $SW_{23}$ changes to the open state from the closed state when the switch $SW_{26}$ is opened, the voltage $V_{i,j}$ inputted through the line $L_{n,i,j}$ just before the switch $SW_{23}$ changes to the open state is held in the capacitor $C_{23}$. When the switch $SW_{23}$ is opened and the switch $SW_{26}$ is closed, the voltage $V_{3,i,j}$ held in the capacitor $C_{23}$ is outputted to the line $L_3$.

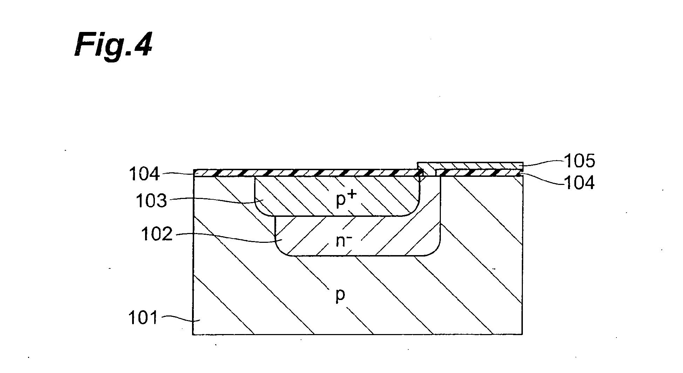

FIG. 4 is a sectional view of the photodiode PD (refer to FIG. 3). It is preferable that each photodiode PD is a buried type as shown in this figure. That is, these photodiodes have an $n^-$-type second semiconductor region 102 formed on a p-type first semiconductor region 101, and a $p^+$-type third semiconductor region 103 formed on the second semiconductor region 102. The first semiconductor region 101 and the second semiconductor region 102 form a pn junction, and the second semiconductor region 102 and the third semiconductor region 103 form a pn junction. An insulating layer 104 is formed on these semiconductor-regions, and the second semiconductor region 102 is electrically connected to a metal layer 105. Thus, when the photodiode is a buried type, the photodiode suppresses the generation of leak current, and has an excellent S/N ratio of optical detection.

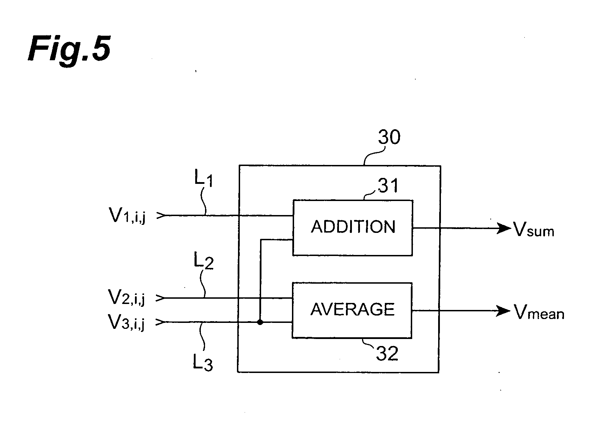

FIG. 5 is an explanatory view of a calculating part 30 of the solid-state image pickup device 1 according to the embodiment. The calculating part 30 is connected to each of the partial holding circuits $h_{i,j}$ (refer to FIG. 3) of 15 pieces in the holding part circuit $H_n$ through the lines $L_1$ to $L_3$, and has an adding part 31 and an average part 32.

The adding part 31 calculates the added value of the voltage $V_{1,i,j}$ outputted from the photosensitive parts $a_{i,j}$ (refer to FIG. 2) of 15 pieces in the section $A_{m,n}$ for each of the sections $A_{m,n}$ (refer to FIG. 1) of MxN pieces in the light detecting part 10, and held in the capacitor $C_{21}$ of each of the partial holding circuits $h_{i,j}$ of 15 pieces in the holding circuit $H_n$, and outputs this added value $V_{sum}$. At this time, the added value of the voltage $V_{3,i,j}$ held in the capacitor $C_{23}$ is reduced from the added value of the voltage $V_{1,i,j}$ held in the capacitor $C_{21}$. That is, the added value $V_{sum}$ is calculated for each of the sections $A_{m,n}$ of $M \times N$ pieces in the light detecting part 10, and is represented by the following formula (1).

$$[\text{Formula 1}] \qquad V_{sum} = \sum_{i,j} \left( V_{1,i,j} - V_{3,i,j} \right) \qquad \ldots (1)$$

The average part 32 calculates the average value of the voltages $V_{2,i,j}$ outputted from the photosensitive parts $a_{i,j}$ of 15 pieces (refer to FIG. 2) in the section $A_{m,n}$ for each of the sections $A_{m,n}$ of MxN pieces in the light detecting part 10 (refer to FIG. 1) and held in the capacitor $C_{22}$ of each of the partial holding circuits $h_{i,j}$ of 15 pieces in the holding circuit $H_n$, and outputs this average value $V_{mean}$. At this time, the average value of the voltages $V_{3,i,j}$ held in the capacitor $C_{23}$ is reduced from the average value of the voltages $V_{2,i,j}$ held in the capacitor $C_{22}$. That is, the average value $V_{mean}$ is calculated for each of the sections A of $M \times N$ pieces in the light detecting part 10, and is represented by the following formula (2).

[Formula 2]

$$V_{mean} = \frac{1}{15} \sum_{i,j} \left( V_{2,i,j} - V_{3,i,j} \right) \qquad \qquad \ldots (2)$$

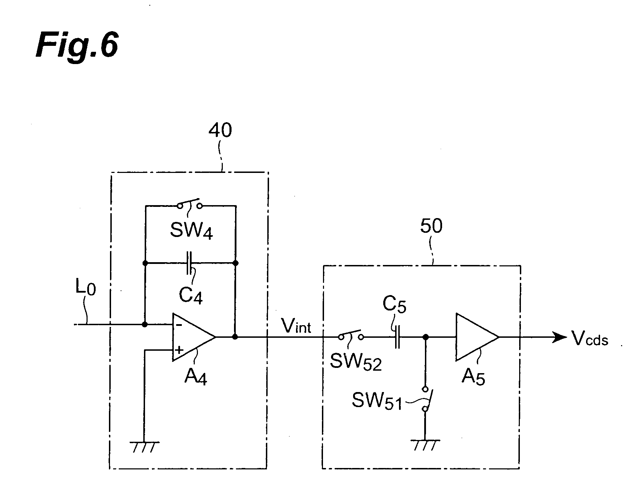

FIG. 6 is a circuit diagram of the integration circuit 40 and CDS circuit 50 of the solid-state image pickup device 1 according to the embodiment.

The integration circuit 40 is provided with an amplifier $A_4$, a capacitor $C_4$ and a switch $SW_4$. A non-inverted input terminal of the amplifier $A_4$ is grounded. The inverted input terminal of the amplifier $A_4$ is connected to the line $L_0$. The capacitor $C_4$ and the switch $SW_4$ are mutually connected in parallel, and are provided between the inverted input terminal and output terminal of the amplifier $A_4$. The capacitor $C_4$ is discharged by closing the switch $SW_4$ in this integration circuit 40, and the output voltage is initialized. When the switch $SW_4$ is opened, the charges flowing-in through the line $L_0$ are accumulated in the capacitor $C_4$, and the voltage $V_{int}$ corresponding to the amount of accumulated charges in this capacitor $C_4$ is outputted.

The CDS circuit 50 has switches $SW_{51}$ and $SW_{52}$, a capacitor $C_5$ and an amplifier $A_5$. The one end of the capacitor $C_5$ is grounded via the switch $SW_{51}$, and is connected to the input terminal of the amplifier $A_5$. The other end of the capacitor $C_5$ is connected to the output terminal of the amplifier $A_4$ of the integration circuit 40 via the switch $SW_{52}$. In this CDS circuit 50, the switch $SW_{51}$ changes to the open state from the closed state at a first time, and the switch $SW_{52}$ changes to the open state from the closed state at a second time, and thereby the voltage $V_{cds}$ corresponding to the difference of the voltages $V_{int}$ outputted from the integration circuit 40 is outputted in each of the first time and second time.

The added value $V_{sum}$ and average value $V_{mean}$ outputted from the calculating part 30 are inputted into the selecting part 60 (refer to FIG. 1), and the voltage $V_{cds}$ (becoming nearly equal to the integration value $V_{int}$ outputted from the integration circuit 40) outputted from the CDS circuit 50 is inputted. When the absolute value of the added value $V_{sum}$ is smaller than a first predetermined value $V_{th1}$, the selecting part 60 outputs the added value $V_{sum}$. When the absolute value of the added value $V_{sum}$ is larger than the first predetermined value $V_{th1}$ and the absolute value of the average value $V_{mean}$ is smaller than the second predetermined value $V_{th2}$, the selecting part 60 outputs the average value $V_{mean}$.

In neither case, the selecting part 60 outputs the integration value $V_{int}$ (that is, voltage $V_{cds}$). That is, the voltage $V_{out}$ outputted from the selecting part 60 is represented by the following formula (3). A select signal denoting whether any of the added value $V_{sum}$, average value $V_{mean}$ and voltage $V_{cds}$ is selected and is outputted as the voltage $V_{out}$ is outputted from the selecting part 60.

[Formula 3]

$$V_{out} = \begin{cases} V_{sum} & \left( |V_{sum}| < V_{th1} \right) \\ V_{mean} & \left( V_{th1} \le |V_{sum}|, |V_{mean}| < V_{th2} \right) \\ V_{cdx} & \left( V_{th2} \le |V_{mean}| \right) \end{cases} \qquad \ldots (3)$$

The voltage $V_{out}$ outputted from the selecting part 60 is inputted into the A/D converter circuit 70 (refer to FIG. 1), and the A/D converter circuit 70 changes the voltage $V_{out}$ into the digital value, and outputs the digital value. The digital value outputted from the A/D converter circuit 70 is inputted into the bit shift circuit 80, and the bit shift circuit 80 shifts the digital value by only the required number of bits corresponding to any selected in the selecting part 60, and outputs the shifted digital value.

That is, when the voltage $V_{out}$ outputted from the selecting part 60 is the added value $V_{sum}$, the bit shift circuit 80 does not shift the bits of the digital value outputted from the A/D converter circuit 70. When the voltage $V_{out}$ outputted from the selecting part 60 is the average value $V_{mean}$, the bit shift circuit 80 shifts the digital value outputted from the A/D converter circuit 70 by only p bits to a higher order. When the voltage $V_{out}$ outputted from the selecting part 60 is the voltage $V_{cds}$, the bit shift circuit 80 shifts the digital value outputted from the A/D converter circuit 70 by only q bits to a higher order (however, p<q).

Next, the operation of the solid-state image pickup device 1 according to the embodiment will be explained.

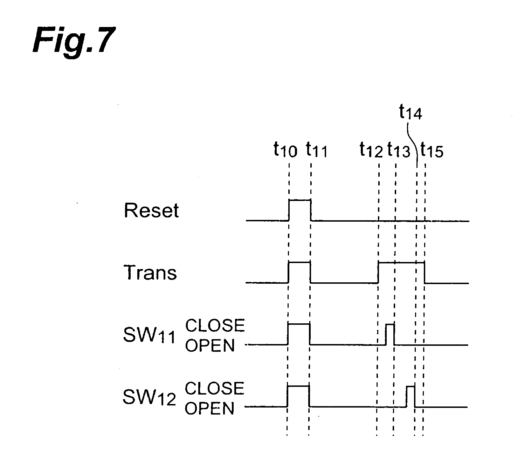

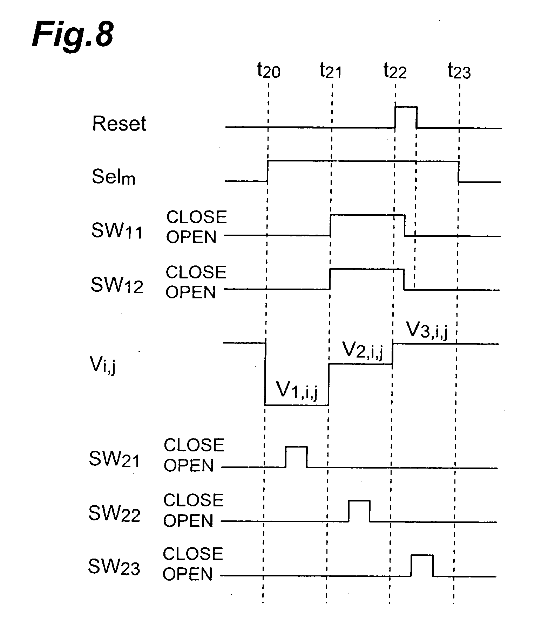

FIG. 7 and FIG. 8 are a timing chart for explaining the operation of the solid-state image pickup device 1 according to the embodiment. The operation to be explained below is performed based on various kinds of control signals outputted from a control part (not shown). The switch $SW_{i,j}$ provided so as to correspond to each photosensitive part $a_{i,j}$ is set so that the bias potential $V_{bias}$ is inputted into the discharge transistor $T_3$.

The level change of the discharge control signal Reset inputted into the gate terminal of the discharge transistor

$T_3$ (refer to FIG. 3) of the photosensitive part $a_{i,j}$, the level change of the transmission control signal Trans inputted into the gate terminal of the transmission transistor $T_2$ of the photosensitive part $a_{i,j}$, the opening/closing operation of the switch $SW_{11}$ of the photosensitive part $a_{i,j}$, and the opening/closing operation of the switch $SW_{12}$ of the photosensitive part $a_{i,j}$ are shown in FIG. 7 beginning at the top. The operation shown in this figure is simultaneously performed in all the photosensitive parts $a_{i,j}$ contained in all the sections $A_{m,n}$ in the light detecting part 10.

At a time $t_{10}$, each of the discharge control signal Reset and transmission control signal Trans becomes a high level, and each of the switch $SW_{11}$ and switch $SW_{12}$ of the photosensitive part $a_{i,j}$ is closed. Thereby, the charges of each of the photodiode PD, first capacitor part $C_{11}$ and second capacitor part $C_{12}$ are initialized.

At a time $t_{11}$, each of the discharge control signal Reset and transmission control signal Trans change to a low level, and each of switch $SW_{11}$ and switch $SW_{12}$ of the photosensitive part $a_{i,j}$ is opened. In this state, when light enters into the photodiode PD, the charges corresponding to the amount of incident light occur in the photodiode, and are accumulated in the junction capacity part of the photodiode PD.

The transmission control signal Trans changes to a high level at a time $t_{12}$, and the transmission control signal Trans changes to a low level at a time $t_{15}$. After the switch $SW_{11}$ is once closed in the period from the time $t_{12}$ to the time $t_{15}$ when the transmission control signal Trans is at a high level, the switch $SW_{11}$ is opened at the time $t_{13}$ after the switch $SW_{11}$ is once closed, and the switch $SW_{12}$ is opened at a time $t_{14}$ after the switch $SW_{12}$ is once closed.

The charges generated in the photodiode PD from the time $t_{11}$ to the time $t_{13}$ are accumulated in the first capacitor part $C_{11}$ by performing the above operation in each photosensitive part $a_{i,j}$, and the charges generated in the photodiode PD from the time $t_{13}$ to the time $t_{14}$ are accumulated in the second capacitor part $C_{12}$.

However, when the capacity value of the first capacitor part $C_{11}$ is smaller than that of the junction capacity part of the photodiode PD and the stronger light enters (that is, when the first capacitor part $C_{11}$ is saturated), the charges which do not exceed the capacity of the first capacitor part $C_{11}$ out of the charges generated in the photodiode PD from the time $t_{11}$ to the time $t_{13}$ are accumulated in the first capacitor part $C_{11}$. In this case, the charges exceeding the capacity of the first capacitor part $C_{11}$ out of the charges generated in the photodiode PD from the time $t_{11}$ to the time $t_{13}$, and the charges generated in the photodiode PD from the time $t_{13}$ to the time $t_{14}$ are accumulated in the second capacitor part $C_{12}$.

FIG. 8 shows the level change of the discharge control signal Reset inputted into the gate terminal of the discharge transistor $T_3$ (refer to FIG. 3) of the photosensitive part $a_{i,j}$, the level change of the m-th line select control signal $Sel_m$ inputted into the gate terminal of the selection transistor $T_4$ of the photosensitive part $a_{i,j}$, the opening/closing operation of the switch $SW_{11}$ of the photosensitive part $a_{i,j}$, the opening/closing operation of the switch $SW_{12}$ of the photosensitive part $a_{i,j}$, the level change of the voltage $V_{i,j}$ outputted from the photosensitive part $a_{i,j}$, the opening/closing operation of the switch $SW_{21}$ of the partial holding circuit $h_{i,j}$, the opening/closing operation of the switch $SW_{22}$ of the partial holding circuit $h_{i,j}$, and the opening/closing operation of the switch $SW_{23}$ of the partial holding circuit $h_{i,j}$ beginning at the top.

Each level change of the discharge control signal Reset and m-th line select control signal $Sel_m$ out of the operation shown in this figure, and each opening/closing operation of the switch $SW_{11}$ and switch $SW_{12}$ are simultaneously performed in all the photosensitive parts $a_{i,j}$ contained in the section $A_{m,1}$ to $A_{m,N}$ of N pieces in the m-th line in the light detecting part 10, and is sequentially performed for the first line to the M-th line in the light detecting part 10.

The m-th line select control signal $Sel_m$ becomes a high level for the period from the time $t_{20}$ after the above time $t_{15}$ to the time $t_{23}$. The discharge control signal Reset becomes a high level for a certain period of time from the time $t_{22}$ out of the period from the time $t_{22}$ to the time $t_{23}$. At the time $t_{20}$, each of the switch $SW_{11}$ and switch $SW_{12}$ is opened. Each of the switch $SW_{11}$ and switch $SW_{12}$ is closed at the subsequent time $t_{21}$, and after the time $t_{22}$ and before the discharge control signal Reset becomes a low level, each of the switch $SW_{11}$ and switch $SW_{12}$ is opened.

Since each of the switch $SW_{11}$ and switch $SW_{12}$ is opened in the period from the time $t_{20}$ to the time $t_{21}$, the first capacitor part $C_{11}$ - is connected to the gate terminal of the amplification transistor $T_1$, and the second capacitor part $C_{12}$ is not connected. Therefore, the voltage $V_{1,i,j}$ outputted to the line $L_{n,i,j}$ through the selection transistor $T_4$ at this time corresponds to the amount of accumulated charges in the first capacitor part $C_{11}$. After the switch $SW_{21}$ of the partial holding circuit $h_{i,j}$ is once closed in this period, the switch $SW_{21}$ is opened, and this voltage $V_{1,i,j}$ is held in the capacitor $C_{21}$ of the partial holding circuit $h_{i,j}$.

Since each of the switch $SW_{11}$ and switch $SW_{12}$ is closed in the period from the time $t_{21}$ to the time $t_{22}$, both the first capacitor part $C_{11}$ and the second capacitor part $C_{12}$ are connected to the gate terminal of the amplification transistor $T_1$. Therefore, the voltage $V_{2,i,j}$ outputted to the line $L_{n,i,j}$ through the selection transistor $T_4$ at this time corresponds to the sum of the amount of accumulated charges in each of the first capacitor part $C_{11}$ and the second capacitor part $C_{12}$. After the switch $SW_{22}$ of the partial holding circuit $h_{i,j}$ is once closed in this period, the switch $SW_{22}$ is opened, and this voltage $V_{2,i,j}$ is held in the capacitor $C_{22}$ of the partial holding circuit $h_{i,j}$.

Since the discharge control signal Reset once becomes a high level in the period from the time $t_{22}$ to the time $t_{23}$, the voltage $V_{3,i,j}$ outputted to the line $L_{n,i,j}$ through the selection transistor $T_4$ at this time denotes a noise ingredient. Two kinds of a fixed pattern noise generated by the threshold variation of the transistor $T_1$ of each pixel and a random noise referred as a KTC noise generated at the time of the opening of the discharge transistor $T_3$ of each pixel are included in this noise ingredient. After the switch $SW_{23}$ of the partial holding circuit $h_{i,j}$ is once closed in this period, the switch $SW_{23}$ is opened, this voltage $V_{3,i,j}$ is held in the capacitor $C_{23}$ of the partial holding circuit $h_{i,j}$. Herein, as shown in FIG. 8, the $SW_{23}$ once closed is opened after a certain period of time after the discharge control signal becomes a low level.

When the switch $SW_{24}$ to $SW_{26}$ of the partial holding circuit $h_{i,j}$ are closed sequentially for holding circuits $H_1$ to $H_N$ in the holding part 20 after the above time $t_{23}$, the voltage $V_{1,i,j}$ to $V_{3,i,j}$ are outputted to the lines $L_1$ to $L_3$ from the partial holding circuit $h_{i,j}$. Each of the added value $V_{sum}$ (the above (1) formula) and average value $V_{mean}$ (the above (2) formula) is calculated as the differential signal between the voltage $V_{1,i,j}$ at the times $t_{20}$ to $t_{21}$ and the voltage $V_{3,i,j}$ at the times $t_{22}$ to $t_{23}$, and the differential signal between the voltage $V_{2,i,j}$ at the times $t_{21}$ to $t_{22}$ and the voltage $V_{3,i,j}$ at the times $t_{22}$ to $t_{23}$ for each of the sections $A_{m,n}$ of $M \times N$ pieces in the light detecting part 10 by the calculating part 30 into which the voltages $V_{1,i,j}$, $V_{2,i,j}$ and $V_{3,i,j}$ are inputted.

Only the former fixed pattern noise can be removed out of the above two kinds of noises with this timing. When the latter random noise needs to also be removed, one signal-frame just before $t_{23}$ for all pixels is stored in an another place, and a difference between the voltage $V_{1,i,j}$ at the times $t_{20}$ to $t_{21}$ and the voltage $V_{2,i,j}$ at the times $t_{21}$ to $t_{22}$ from the signal just before $t_{23}$ before one frame is found. However, the reset operation at the times $t_{10}$ to $t_{11}$ is not required at this time.

The added value $V_{sum}$ and average value $V_{mean}$ outputted from the calculating part 30 are inputted into the selecting part 60. When the absolute value of the added value $V_{sum}$ is smaller than the first predetermined value $V_{th1}$ (that is, when the amount of incident light to the section $A_{m,n}$ is comparatively small and the first capacitor part $C_{11}$ is not saturated in the photosensitive part $a_{i,j}$), the added value $V_{sum}$ is selected as the voltage $V_{out}$ outputted from the selecting part 60 in the selecting part 60. On the other hand, when the absolute value of the added value $V_{sum}$ is larger than the first predetermined value $V_{th1}$ (that is, when the amount of incident light to the section $A_{m,n}$ is comparatively large and the first capacitor part $C_{11}$ is saturated in the photosensitive part $a_{i,j}$), the average value $V_{mean}$ is selected as the voltage $V_{out}$ outputted from the selecting part 60.

When the light detecting sensitivity is set to $\alpha$ in the case that the added value $V_{sum}$ is outputted from the selecting part 60 at this time and the light detecting sensitivity is set to $\beta$ in the case that the average value $V_{mean}$ is outputted from the selecting part 60, the ratio of $\alpha$ to $\beta$ is represented by the following formula (4). In this embodiment, $K$ is equal to 15. For example, this ratio can be set to 64:1 by appropriately setting the capacity value of each of the first capacitor part $C_{11}$ and second capacitor part $C_{12}$.

$$[\text{Formula 4}] \qquad \alpha : \beta = \frac{K}{C_{11}} : \frac{1}{C_{11} + C_{12}} = \frac{K(C_{11} + C_{12})}{C_{11}} : 1 \qquad \ldots (4)$$

However, when the amount of incident light to a certain section $A_{m,n}$ is still larger, both the first capacitor part $C_{11}$ and the second capacitor part $C_{12}$ may be saturated in the photosensitive part $a_{i,j}$ contained in the section $A_{m,n}$. In such a case, the discharge control signal Reset and each transmission control signal Trans are respectively set to a high level in each photosensitive part $a_{i,j}$ contained in the section $A_{m,n}$, and the charges generated in the photodiode PD are inputted into the integration circuit 40 via the switch $SW_{i,j}$ and the line $L_0$.

The charges generated in all the photodiodes PD in the section $A_{m,n}$ are accumulated in the capacitor $C_4$ of the integration circuit 40, and the voltage $V_{int}$ corresponding to the amount of accumulated charges in the capacitor $C_4$ is outputted from the integration circuit 40. The voltage outputted from the integration circuit 40 is inputted in the CDS circuit 50 during the charge accumulation period in the integration circuit 40, and the voltage $V_{cds}$ corresponding to the difference in the voltages outputted from the integration circuit 40 at each of the initial time and finish time of the charge accumulation period is outputted.

Since the capacity value of the capacitor $C_4$ of the integration circuit 40 can be enlarged as compared with the first capacitor part $C_{11}$ and second capacitor part $C_{12}$ of each photosensitive part $a_{i,j}$, the capacitor $C_4$ can be hardly saturated even if the amount of incident light to the section $A_{m,n}$ is still larger.

When the absolute value of the added value $V_{sum}$ is larger than the first predetermined value $V_{th1}$, and the absolute value of the average value $V_{mean}$ is smaller than the second predetermined value $V_{th2}$ (that is, when the second capacitor part $C_{12}$ is not saturated although the amount of incident light to the section $A_{m,n}$ is comparatively larger and the first capacitor part $C_{11}$ is saturated in the photosensitive part $a_{i,j}$), the average value $V_{mean}$ is selected as the voltage $V_{out}$ outputted from the selecting part 60.

In neither case (when the amount of incident light to the section $A_{m,n}$ is still larger and the both the first capacitor part $C_{11}$ and the second capacitor part $C_{12}$ are saturated in the photosensitive part $a_{i,j}$), the voltage $V_{cds}$ is selected as

the voltage $V_{out}$ outputted from the selecting part 60. That is, the voltage $V_{out}$ outputted from the selecting part 60 is represented by the above formula (3).

The A/D conversion of the voltage $V_{out}$ outputted from the selecting part 60 is performed by the A/D converter circuit 70, and the digital value corresponding to the voltage $V_{out}$ is outputted from the A/D converter circuit 70. The digital value outputted from this A/D converter circuit 70 is shifted by only the required number of bits corresponding to any selected in the selecting part 60 by the bit shift circuit 80.

When the voltage $V_{out}$ outputted from the selecting part 60 is added value $V_{sum}$, the bit shift of the digital value outputted from the A/D converter circuit 70 is not performed in the bit shift circuit 80. When the voltage $V_{out}$ outputted from the selecting part 60 is the average value $V_{mean}$, the digital value outputted from the A/D converter circuit 70 is shifted by only p bits to a higher order in the bit shift circuit 80. When the voltage $V_{out}$ outputted from the selecting part 60 is the voltage $V_{cds}$, the digital value outputted from the A/D converter circuit 70 is shifted by only q bits to a higher order in the bit shift circuit 80.

Herein, p and q are appropriately set according to the capacity value of the first capacitor part $C_{11}$ of each photosensitive part $a_{i,j}$, the sum of the capacity values of the first capacitor part $C_{11}$ and second capacitor part $C_{12}$ of each photosensitive part $a_{i,j}$, the number of photosensitive parts $a_{i,j}$ contained in the section $A_{m,n}$ and the capacity value of the capacitor $C_4$ of the integration circuit 40. The digital value outputted from the bit shift circuit 80 denotes the amount of incident light to each section $A_{m,n}$ regardless of any input voltage selected in the selecting part 60.

As described above, the solid-state image pickup device 1 according to the embodiment can measure the amount of incident light to each section $A_{m,n}$ with a high dynamic range, and can obtain an image excellent in contrast. Since the solid-state image pickup device 1 according to the embodiment does not amplify the signal charges outputted from the photodiode with the noise by the integration circuit when the amount of incident light is small, but outputs the charges generated in the photodiode PD in the photosensitive part $a_{i,j}$ in each section $A_{m,n}$ through the source follower circuit consisting of the amplification transistor $T_1$ and the selection transistor $T_4$, the solid-state image pickup device 1 can obtain an image excellent in the S/N ratio.

It is preferable that the capacity value of the capacity part for accumulating the charges in the integration circuit 40 can be set in multiple-stages. Thereby, the dynamic range of the optical detection can be further enlarged.

**Industrial Applicability**

The present invention can be used for the photosensitive part and the solid-state image pickup device.

**Claims**

1.　A photosensitive part comprising:

　　a photodiode for generating charges corresponding to the intensity of incident light;
　　a first capacitor part and a second capacitor part for respectively accumulating the charges;
　　an amplification transistor having a gate terminal connected to at least one of the first capacitor part and the second capacitor part and outputting a voltage corresponding to the charges accumulated in at least one of the first capacitor part and the second capacitor part, connected to the gate terminal;
　　a transmission transistor for transferring the charges generated in the photodiode to the first capacitor part via a first switch and transferring the charges to the second capacitor part via a second switch;
　　a discharge transistor for initializing the charges of each of the first capacitor part and the second capacitor part; and
　　a selection transistor for alternatively outputting the voltage outputted from the amplification transistor.

2.　A solid-state image pickup device comprising:

　　a light detecting part including sections $A_{1,1}$ to $A_{M,N}$ of M×N pieces one-dimensionally or two-dimensionally arranged and having the photosensitive parts of K pieces according to claim 1 arranged in a section $A_{m,n}$ in the m-th line and n-th column;
　　a holding part for holding first voltages outputted through the selection transistor from the amplification transistor when the gate terminal of the amplification transistor of each of the photosensitive part of K pieces contained in the section $A_{m,n}$ is connected to at least one of the first capacitor part and the second capacitor part, and holding second voltages outputted through the selection transistor from the amplification transistor when the gate terminal of the amplification transistor is connected to both the first capacitor part and the second capacitor part; and

a calculating part for calculating and outputting the added value of the first voltages outputted from each of the photosensitive parts of K pieces contained in the section $A_{m,n}$ and held by the holding part, and calculating and outputting the average value of the second voltages outputted from each of the photosensitive part of K pieces contained in the section $A_{m,n}$ and held by the holding part (M and N are an integer of 1 or more; at least one of M and N is an integer of 2 or more; K is an integer of 2 or more; m is an optional integer of 1 to M; and n is an optional integer of 1 to N).

3. The solid-state image pickup device according to claim 2, further comprising a selecting part for inputting the added value and average value outputted from the calculating part for each section $A_{m,n}$, outputting the added value when the absolute value of the added value is smaller than a predetermined value and outputting the average value when not so.

4. The solid-state image pickup device according to claim 2, further comprising:

a connection switching part having a first end provided for each of the photosensitive parts of K pieces contained in the section $A_{m,n}$ and connected to the discharge transistor of the photosensitive part, and a second end for inputting bias potential for initializing the charges of each of the first capacitor part and second capacitor part of the photosensitive part, and a third end, and electrically connecting between the first end and the second end, or between the first end and the third end; and

an integration circuit having an input terminal connected to the third end of the connection switching part, accumulating the charges flowing-in through the first end and the third end of the connection switching part from the photosensitive parts of K pieces contained in the section $A_{m,n}$ in a capacitor, and outputting the integration value corresponding to the amount of accumulated charges.

5. The solid-state image pickup device according to claim 4, further comprising a. selecting part for inputting the added value and average value outputted from the calculating part for each section $A_{m,n}$, inputting the integration value outputted from the integration circuit, outputting the added value when the absolute value of the added value is smaller than a first predetermined value, outputting the average value when the absolute value of the added value is larger than the first predetermined value and the absolute value of the average value is smaller than a second predetermined value, and outputting the integration value in neither case.

# Fig.1

| $A_{1,1}$ | $A_{1,2}$ | $\cdots$ | $A_{1,n}$ | $\cdots$ | $A_{1,N}$ |
| $A_{2,1}$ | $A_{2,2}$ | $\cdots$ | $A_{2,n}$ | $\cdots$ | $A_{2,N}$ |
| $\vdots$ | $\vdots$ | $\ddots$ | $\vdots$ | $\ddots$ | $\vdots$ |
| $A_{m,1}$ | $A_{m,2}$ | $\cdots$ | $A_{m,n}$ | $\cdots$ | $A_{m,N}$ |

# Fig.2

| | | | | |
|---|---|---|---|---|
| $a_{1,1}$ | $a_{1,2}$ | $a_{1,3}$ | $a_{1,4}$ | $a_{1,5}$ |
| $a_{2,1}$ | $a_{2,2}$ | $a_{2,3}$ | $a_{2,4}$ | $a_{2,5}$ |
| $a_{3,1}$ | $a_{3,2}$ | $a_{3,3}$ | $a_{3,4}$ | $a_{3,5}$ |

$A_{m,n}$

| | | | | |
|---|---|---|---|---|
| $h_{1,1}$ | $h_{1,2}$ | $h_{1,3}$ | $h_{1,4}$ | $h_{1,5}$ |
| $h_{2,1}$ | $h_{2,2}$ | $h_{2,3}$ | $h_{2,4}$ | $h_{2,5}$ |
| $h_{3,1}$ | $h_{3,2}$ | $h_{3,3}$ | $h_{3,4}$ | $h_{3,5}$ |

$H_n$

## Fig.3

# Fig.4

# Fig.5

# Fig.6

# Fig.7

# Fig.8

## INTERNATIONAL SEARCH REPORT

| | International application No. |
|---|---|
| | PCT/JP2005/006301 |

| A. CLASSIFICATION OF SUBJECT MATTER |
|---|
| Int.Cl$^7$  H04N5/335, G01J1/44, 1/46 |
| According to International Patent Classification (IPC) or to both national classification and IPC |

| B.   FIELDS SEARCHED |
|---|
| Minimum documentation searched (classification system followed by classification symbols) |
| Int.Cl$^7$  H04N5/335, G01J1/44, 1/46 |

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2005 |
| Kokai Jitsuyo Shinan Koho | 1971-2005 | Toroku Jitsuyo Shinan Koho | 1994-2005 |

Electronic data base consulted during the international search (name of data base and, where practicable, search terms used)

### C.   DOCUMENTS CONSIDERED TO BE RELEVANT

| Category* | Citation of document, with indication, where appropriate, of the relevant passages | Relevant to claim No. |
|---|---|---|
| X<br>A | JP 2000-165754 A  (Canon Inc.),<br>16 June, 2000 (16.06.00),<br>Par. Nos. [0047] to [0058]; Figs. 12 to 15<br>(Family: none) | 1<br>2-5 |
| X<br>A | JP 8-122149 A  (Nissan Motor Co., Ltd.),<br>17 May, 1996 (17.05.96),<br>Par. Nos. [0036] to [0070]; Figs. 1 to 28<br>& US 5705807 A1 | 1<br>2-5 |
| A | JP 2000-221005 A  (Hamamatsu Photonics Kabushiki Kaisha),<br>11 August, 2000 (11.08.00),<br>Par. Nos. [0013] to [0023]; Fig. 2<br>(Family: none) | 1-5 |

| ☒  Further documents are listed in the continuation of Box C. | ☐  See patent family annex. |
|---|---|

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 28 June, 2005 (28.06.05) | 26 July, 2005 (26.07.05) |

| Name and mailing address of the ISA/ | Authorized officer |
|---|---|
| Japanese Patent Office | |
| Facsimile No. | Telephone No. |

Form PCT/ISA/210 (second sheet) (January 2004)

**INTERNATIONAL SEARCH REPORT**

| International application No. |
|---|
| PCT/JP2005/006301 |

C (Continuation).   DOCUMENTS CONSIDERED TO BE RELEVANT

| Category* | Citation of document, with indication, where appropriate, of the relevant passages | Relevant to claim No. |
|---|---|---|
| A | JP 8-256293 A  (Fujitsu Ltd.), 01 October, 1996 (01.10.96), Full text; Figs. 1 to 11 (Family: none) | 1-5 |

Form PCT/ISA/210 (continuation of second sheet) (January 2004)

**EP 1 732 315 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 3146502 B